Europäisches Patentamt

European Patent Office

Office européen des brevets

(19)

(11) Veröffentlichungsnummer: **0 012 911**
**B1**

(12)  # EUROPÄISCHE PATENTSCHRIFT

(45) Veröffentlichungstag der Patentschrift:
27.07.83

(21) Anmeldenummer: **79105062.8**

(22) Anmeldetag: **10.12.79**

(51) Int. Cl.³: **G 05 D 3/00,** H 01 L 21/70,
H 01 L 21/68

(54) Einrichtung zum Feinausrichten plattenförmiger Werkstücke, z.B. Halbleiterwafer.

(30) Priorität: **29.12.78 US 974574**

(43) Veröffentlichungstag der Anmeldung:
**09.07.80 Patentblatt 80/14**

(45) Bekanntmachung des Hinweises auf die Patenterteilung:
**27.07.83 Patentblatt 83/30**

(84) Benannte Vertragsstaaten:
**DE FR GB**

(56) Entgegenhaltungen:
**keine**
**DE-A-2 748 101**
**DE-B-2 304 489**
**FR-A-2 330 030**
**US-A-3 928 094**
**US-A-4 068 947**
**IMB — TECHNICAL DISCLOSURE BULLETIN,**
**Band 16, Nr. 10, März 1974, J. W. BUECHELE**
**»Semiconductor Leveling System«, Seiten 3255**
**bis 3256**

(73) Patentinhaber: **International Business Machines**
**Corporation, Old Orchard Road, Armonk, N.Y. 10504 (US)**

(72) Erfinder: **Cachon, Rene Paul, 14 Helen Drive, Wappinger**
**Falls, New York 12590 (US)**

(74) Vertreter: **Willich, Wolfgang, Dipl.-Ing., Schönaicher**
**Strasse 220, D-7030 Böblingen (DE)**

## Einrichtung zum Feinausrichten
## plattenförmiger Werkstücke, z. B. Halbleiterwafer

Die Erfindung betrifft eine Einrichtung zum planparallelen Feinausrichten plattenförmiger Werkstücke, z. B. Halbleiterwafer, zu einer Referenzebene, z. B. in die Abbildungsebene eines optischen Systems gemäß dem ersten Teil des Anspruchs 1. Eine derartige Einrichtung ist aus der DE-A-2 748 101 bekannt.

Die Herstellung integrierter Schaltungen erfordert eine Anzahl aufeinanderfolgender Bearbeitungs- und Behandlungsstufen, wie z. B. Ätzen, Diffundieren, Metallisieren u. a., und für einige dieser Stufen werden Masken bestimmter Gestaltungen verwendet. Die Anfertigung solcher Masken erfolgt üblicherweise mittels entsprechender Musterbilder in den erforderlichen geometrischen Formen und Figuren, und mit solchermaßen angefertigten Masken werden entsprechende Muster mittels Belichtung der mit Photowiderstand beschichteten Oberfläche auf das Werkstück, z. B. den Halbleiterwafer, projiziert. Durch nachfolgendes Ätzen entstehen sodann auf der Oberfläche des Werkstücks entsprechende — negative oder positive — Muster aus nichtleitendem, halbleitendem bzw. leitendem Material.

Bis zur Fertigstellung eines solchen Halbleiter-Schaltungselements sind, je nach Art der aufzubringenden Muster, mit unterschiedlichen Masken eine Mehrzahl solcher Projektionsschritte durchzuführen, nämlich bisweilen bis zu 25 Schritte oder mehr. Auf dem Wafer befinden sich dann mehrere hundert, oder sogar über tausend Schaltelemente mit bis zu je etwa 700 Schaltfunktionen. Die Abmessungen der einzelnen Schaltelemente liegen hierbei in der Größenordnung von 0,1 mm Länge und Breite, mit einzelnen Anschlüssen von 0,01 mm und darunter. Die hohe Dichte der Einzelelemente, die im Laufe der Entwicklung zur Miniaturisierung noch im Steigen begriffen ist, verlangt ein entsprechend genaues Ausrichten des Werkstücks für jeden einzelnen Belichtungsvorgang.

Zum Stand der Technik werden ferner genannt das Halbleiter-Ausrichtsystem gemäß IBM Technical Disclosure Bulletin, Band 16, Nr. 10, Seiten 3255/56, sowie die US-PS 4 068 947. Bei dem in der zuletzt genannten Patentschrift beschriebenen System zur Ausrichtung von Halbleiterwafern werden die Wafer in vier Koordinaten ausgerichtet, nämlich in der X- und Y-Richtung, in der Z-Richtung sowie in Drehrichtung. Dabei liegen für die Ausrichtung in Z-Richtung zum Zwecke der Justage des Werkstücks in bezug auf die Abbildungsebene des optischen Systems Halteelemente eines Adapterringes auf der Oberfläche des Wafers nahe dessen Umfang an, mit der Folge, daß ein Teil der Werkstückoberfläche bei den genannten Behandlungsvorgängen abgedeckt ist. Weiterhin treten wegen der auf die Oberfläche des Werkstücks ausgeübten Haltekräfte im Bereich der Halteelemente Ungenauigkeiten auf, so daß die genaue Ausrichtung in bezug auf die Abbildungsebene beeinträchtigt werden kann. Ein weiterer Nachteil ist, daß sich auf den Halteelementen Teile der auf der Werkstückoberfläche befindlichen Photowiderstandsschicht absetzen, was wiederum in bezug auf die genaue Ausrichtung des Werkstücks nachteilig ist und überdies regelmäßiges Reinigen der Halteelemente erforderlich macht, was sich selbstverständlich nachteilig auf den wirtschaftlichen Einsatz der Anlage auswirkt.

Durch die Erfindung wird die Aufgabe gelöst, die bekannten Einrichtungen insbesondere dahingehend zu verbessern, daß die Ausrichtung des Werkstücks zur Abbildungsebene ohne Beeinträchtigung der Werkstückoberfläche und des Justageergebnisses durchgeführt werden kann. Die Lösung dieser Aufgabe ist im Patentanspruch 1 angegeben.

Ein Ausführungsbeispiel der Erfindung wird nachfolgend anhand der Zeichnungen erläutert. Es zeigt

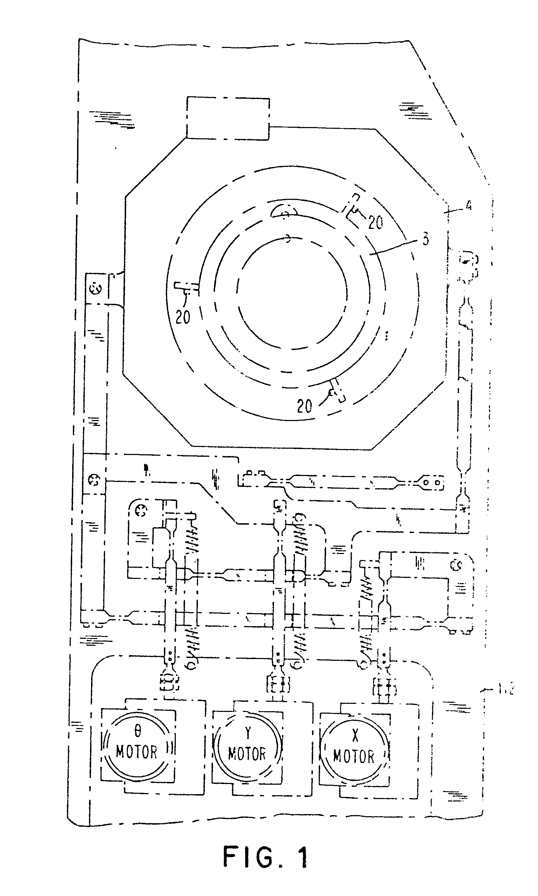

Fig. 1 eine Draufsicht auf eine Einrichtung zur Feinausrichtung von Halbleiterwafern in bezug auf eine Abbildungsebene,

Fig. 2 eine Schnittdarstellung der Einrichtung gemäß Fig. 1,

Fig. 2A eine vergrößerte Schnittansicht einer Baugruppe gemäß Fig. 2,

Fig. 3 eine Draufsicht auf die Saugkopfanordnung der in den vorhergehenden Figuren dargestellten Einrichtung,

Fig. 3A eine Draufsicht entsprechend Fig. 3, mit Darstellung der Antriebsvorrichtungen für das Ein- und Ausschwenken der Abtastköpfe,

Fig. 4 eine vergrößerte Teil-Schnittdarstellung des Trägersockels und einer Biegeeinheit,

Fig. 5 eine vereinfachte elektrische Schaltung für die Steuereinheit gemäß Fig. 2,

Fig. 6 eine schematische Schaltungsdarstellung der Druckregler für die Vakuumeinrichtungen und

Fig. 7 ein Kraft-/Wegdiagramm für eine Biegeeinheit der Einrichtung gemäß Fig. 2.

Die nachfolgend beschriebene Einrichtung ermöglicht die Feinjustage von plattenförmigen Werkstücken in bezug auf die Abbildungsebene eines optischen Systems mit einer Genauigkeit von ±0,5 μm.

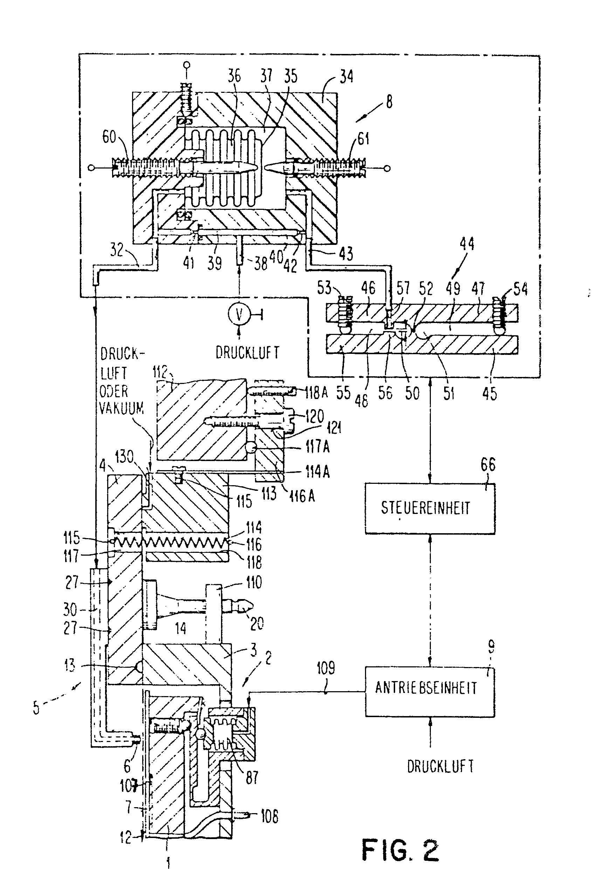

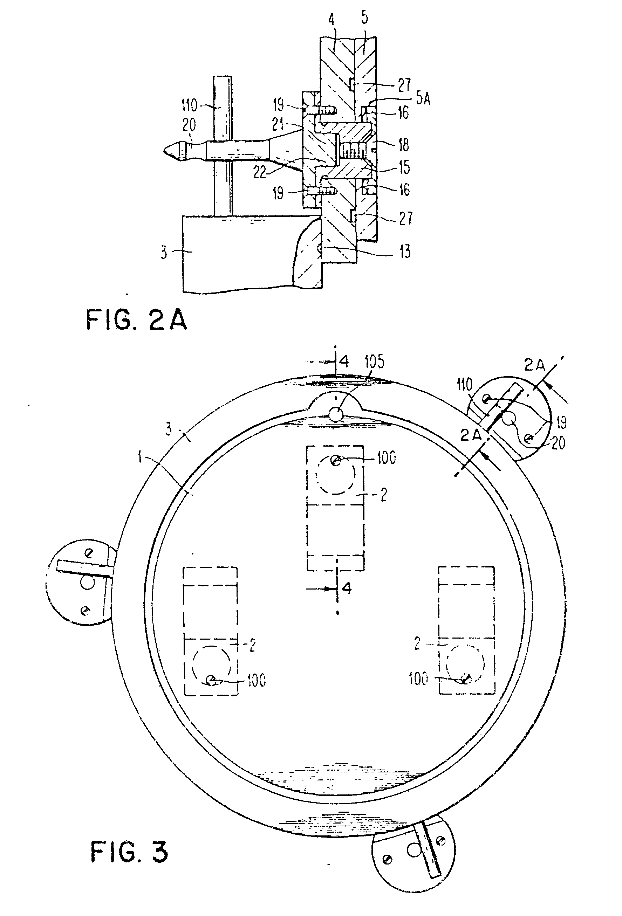

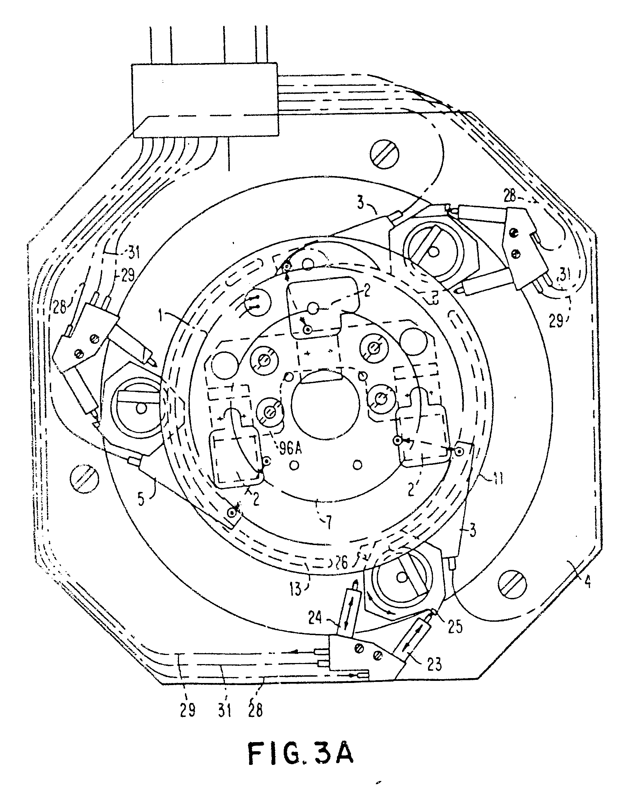

Das in den Zeichnungen dargestellte System enthält einen Trägersockel 1, welcher zu seiner Verstellung auf drei pneumatisch betätigten Biegeeinheiten 2 gelagert ist (Fig. 2 und 3), die bezüglich des Trägersockels 1 mit gleichmäßigen Winkelabständen, also um je 120° gegeneinander versetzt angeordnet sind. Die Biegeeinheiten 2 sind auf einem Saugkopfsockel 3 gelagert, welcher seinerseits auf einer Grundplatte 4 montiert ist. Die Grundplatte 4 ist, wie später noch erläutert wird, als X-/Y-Tisch ausgebildet, welcher in X-, Y- und Drehrichtung verstellbar ist, um ein Werkstück axial zu einem optischen System auszurichten.

Auf der Grundplatte 4 befinden sich, jeweils den einzelnen Biegeeinheiten 2 gegenüberliegend, drei entsprechend über den Umfang verteilte, also um einen Winkel von je 120° gegeneinander versetzt angeordnete Abtastköpfe 5 mit Abtastdüsen 6, die mit der Oberfläche eines auf dem Trägersockel 1 befindlichen Werkstücks 7, z. B. eines Wafers, zusammenwirken (Fig. 2), derart, daß die pneumatisch betriebenen Abtastdüsen 6 in üblicher Weise die Druckveränderungen an ihrer Mündung feststellen, die durch Veränderung des Abstandes zwischen Düsenmündung und Werkstück 7 verursacht werden. Die entsprechenden Abtast-Ausgangssignale werden einem Differentialdruckschalter 8 zugeführt, dessen Ausgangssignale zu einer Antriebseinheit 9 gelangen, von der aus die Bewegungen der Biegeeinheiten 2 und damit die Veränderungen des Trägersockels 1 zum Zwecke der Ausrichtung des Werkstücks 7 zur Abbildungsebene des optischen Systems gesteuert werden.

Die Grundplatte 4 enthält gemäß Fig. 3A eine Öffnung 11 zum Durchlaß der Abbildungsstrahlen eines optischen Projektionssystems, wie es bei der Herstellung von Halbleiterwafern Verwendung findet, und seine untere Fläche ist als Abbildungsebene 12 in bezug auf das optische System definiert, zu welcher die Oberfläche des Werkstücks 7 planparallel auszurichten ist.

In der unteren Fläche der Grundplatte 4 befinden sich Vakuumnuten 13, die, wenn sie an Vakuum angeschlossen werden, über den Saugkopfsockel 3 einen Saugkopf 14 auf der unteren Fläche der Grundplatte 4 festhalten. Auf der oberen Fläche der Grundplatte 4 befinden sich die drei Abtastköpfe 5, von denen jeder auf einer Achse 15 drehbar gelagert ist (Fig. 2A). In einer Ringnut 5A ist eine Lagerringfeder 16 eingelegt und mittels einer Deckplatte und einer Schraube 18 in ihrer Lage gesichert. Das entgegengesetzte Ende der Achse 15 ist so als Flansch ausgebildet, daß es mittels Stiftschrauben 19 und zusammen mit einem entsprechenden Flansch eines Registrierstiftes 20 an der unteren Fläche der Grundplatte 4 befestigt werden kann. Die Ausrichtung des Registrierstiftes 20 auf dem Saugkopf 14 erfolgt mittels eines Stempelelements 21, das in einer Bohrung 22 der Achse 15 geführt ist.

Die Abtastköpfe 5 können zwei Positionen einnehmen, nämlich »Ein« und »Aus«. Die Verstellung der Abtastköpfe 5 zwischen diesen Positionen erfolgt unter der Steuerung zweier pneumatischer Zylinder 23 und 24 (Fig. 3A), die auf zugeordnete Anschläge 25 bzw. 26 an den Abtastköpfen 5 wirksam sind. Werden über Schlauchleitungen 28 und 29 die Zylinder 23 eingeschaltet, bewirkt der dadurch ausgelöste Kolbenschub über den Anschlag 25 eine Drehbewegung des Abtastkopfes 5 in seine »Ein«-Position, in welcher die zugeordneten Abtastdüsen 6 auf die entsprechenden Biegeeinheiten 2 eingestellt werden. Wenn andererseits über die Schlauchleitungen 31 und 29 die »Aus«-Zylinder 24 eingeschaltet werden, werden deren Kolben auf die Anschläge 26 wirksam, mit der Folge, daß die Abtastköpfe 5 in ihren durch die Lagerringfedern 16 gebildeten Lagern aus dem Bereich des Abbildungsstrahls des optischen Systems ausgeschwenkt werden. Unterhalb der unteren Fläche der Abtastköpfe 5, auf der Oberfläche der Grundplatte 4, befinden sich Nuten 27, die über (nicht gezeigte) flexible Leitungen alternativ an eine Vakuumquelle oder eine Druckluftquelle angeschlossen werden können. Für die Dauer der Drehbewegung der Abtastköpfe 5 wird den Nuten 27 Druckluft zugeführt, so daß sich für die Drehbewegung der Abtastköpfe 5 eine Luftlagerschicht bildet. Andererseits werden in den Positionen »Abtasten« und »Ruhe« die Nuten 27 an eine Vakuumquelle angeschlossen, so daß in diesem Fall die Abtastköpfe 5 auf der Grundplatte 4 festgehalten werden. In der Abtastposition über den Werkstücken 7 werden die Abtastdüsen 6 in eine Entfernung von etwa 75 $\mu$m $\pm$ 5 $\mu$m von der Referenzebene eingestellt, welche der unteren Fläche der Grundplatte 4 entspricht. Hierbei bilden die Abtastdüsen 6 einen Abtastluftstrahl, welcher als Meßstahl für den Abstand zwischen dem Werkstück 7 und der Mündung der Abtastdüse 6 wirkt. Die Luftzufuhr zur Abtastdüse 6 erfolgt durch einen Kanal 30 im Abtastkopf 5, welcher, wie Fig. 2 zeigt, mit der Abtastausgangsleitung 32 des Differentialdruckschalters 8 verbunden ist.

Jedem der Abtastköpfe 5 und der Biegeeinheiten 2 ist ein Differentialdruckschalter 8 zugeordnet, jeder der Differentialdruckschalter 8 enthält ein Gehäuse 34 aus Isoliermaterial mit einer Kammer, in welcher ein leitender metallischer Faltenbalg 35 angeordnet ist, welcher zwei Luftkammern 36, im Innern des Balges, und 37, außerhalb des Balges, bildet. Eine Einlaßleitung 38 ist über ein Ventil an eine Luftdruckquelle mit einem Druck von etwa 1 bar angeschlossen und verzweigt sich in Kanäle 39 und 40. Auf diese Weise gelangt ein Teil der zugeführten Druckluft durch eine Drossel 41 zur Abtastausgangsleitung 32 und der Luftkammer 36, während der andere Teil des Druckluftstromes durch eine der Drossel 41 entsprechende Drossel 42 zur Luftkammer 37 und einer Steuerausgangsleitung 43 geleitet wird, an welche ein Druckregelventil 44 angeschlossen ist.

Das Druckregelventil 44 besteht aus einem einzigen Metallblock 45, welcher mittels Einschnitten 48 und 49 in zwei frei austragende Steuerarme 46 und 47 geteilt ist. Mittels Bohrungen 50 und 51 sind die Abstände zwischen dem Steuerarm 46 und dem zugeordneten Schenkel 55 sowie dem Steuerarm 47 und dem zugeordneten Schenkel vergrößert, wodurch eine dünne Biegeverbindung 52 gebildet ist. Eine Grobstellschraube 53 und eine Feinstellschraube 54 ermöglichen eine Justage des Abstandes des Schenkels 55 vom Steuerarm 46, zum Zwecke der Veränderung des Abstandes einer Steuerfläche 56 von einer mit der Steuerausgangsleitung 43 des Differentialdruckschalters 8 verbundenen Luftdüse 57. Die Einstellung des beschriebenen Druckregelventils 44 beeinflußt die Aufteilung des Luftstroms im Differentialdruckschalter 8 in bezug auf den gewünschten Abstand zwischen der Abtastdüse 6 und der Oberfläche des Werkstücks 7, wenn sich diese in der Abbildungsebene 12 des optischen Systems befindet.

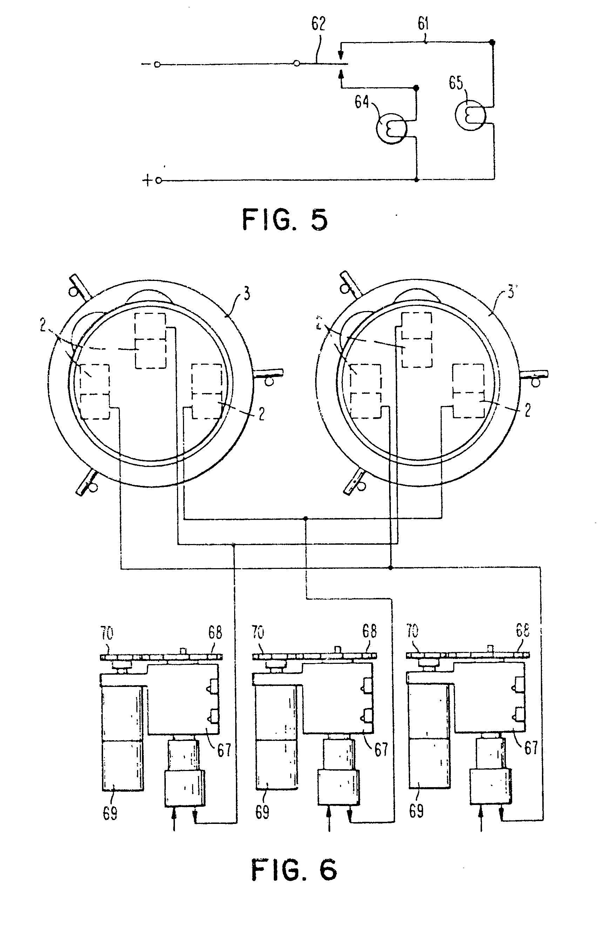

Die. Erzeugung und Übertragung der Ausgangssignale des Differentialdruckschalters 8 in Abhängigkeit von den von der Abtastdüse 6 erhaltenen pneumatischen Signalen erfolgt mittels einer Steuerschaltung, wie sie in Fig. 5 schematisch dargestellt ist. Ein unterer Abtastkontakt 60 ragt in die Luftkammer 36 innerhalb des Faltenbalges 35, und ein damit axial ausgerichteter oberer Abtastkontakt 61 ragt in die Luftkammer 37 außerhalb des Faltenbalgs 35. Ein Schaltarm 62 befindet sich in Kontakt mit dem Flansch des Faltenbalgs 35 und bewirkt über entsprechende Schaltkreise, die in Fig. 5 mit 64 und 65 bezeichnet und Teil der Steuereinheit 66 sind, die Steuerung der Antriebseinheit 9 für die Betätigung der Biegeeinheiten 2 (Fig. 2).

Während des Betriebes der beschriebenen Anordnung bestimmt der Spalt zwischen der Oberfläche des Werkstücks 7 und der Mündung der Abtastdüse 6, in Verbindung mit der durch die Einlaßleitung 38 zugeführten Druckluft, die Ausdehnung des Faltenbalges 35 im Differentialdruckschalter 9. Überschreitet die Größe des Spaltes an der Abtastdüse 6 zur Abbildungsebene 12 einen bestimmten festgelegten Wert, z. B. 75 µm, so steigt der Druck in der Luftkammer 37 über denjenigen in der Luftkammer 36 an, mit der Folge, daß der Faltenbalg 35 in Richtung zum Abtastkontakt 60 zusammengedrückt und die Antriebseinheit 9 über die Steuereinheit 66 zur Anhebung des Sockels 1 wirksam wird, sich also der Spalt an der Abtastdüse 6 zum Werkstück 7 verringert. Im umgekehrten Fall, wenn die Werkstückfläche sich in einem geringeren als dem vorgegebenen Abstand von der Abtastdüse 6 befindet, erhöht sich der Druck innerhalb der Luftkammer 36 gegenüber demjenigen in der Luftkammer 37 an der Außenseite des Faltenbalges 35, so daß dieser sich ausdehnt und den Abtastkontakt 61 betätigt, mit der Folge, daß die Antriebseinheit 9 zur Vergrößerung des Luftspaltes an der Abtastdüse 6 wirksam wird. Ist das Werkstück 7 auf diese Weise auf den gewünschten Abstand von allen drei Abtastdüsen 6 eingestellt, so befindet sich die Werkstückoberfläche genau innerhalb der Abbildungsebene 12 des optischen Systems.

Jede der Antriebseinheiten 9 ist mit einer der Biegeeinheiten 2 verbunden und enthält einen Druckregler 67 (Fig. 6) für einen Druckbereich bis 4 bar sowie ein Stirnrad 68, welches mit einem Ritzel 70 eines Antriebsmotors 69 im Eingriff steht. Der Antriebsmotor 69 bewirkt die Regelung des Druckes, etwa im Bereich von 5 bis 6 bar, welcher zu der zugeordneten Biegeeinheit 2 in Abhängigkeit von der durch die Steuereinheit 66 bestimmten Richtung übertragen wird.

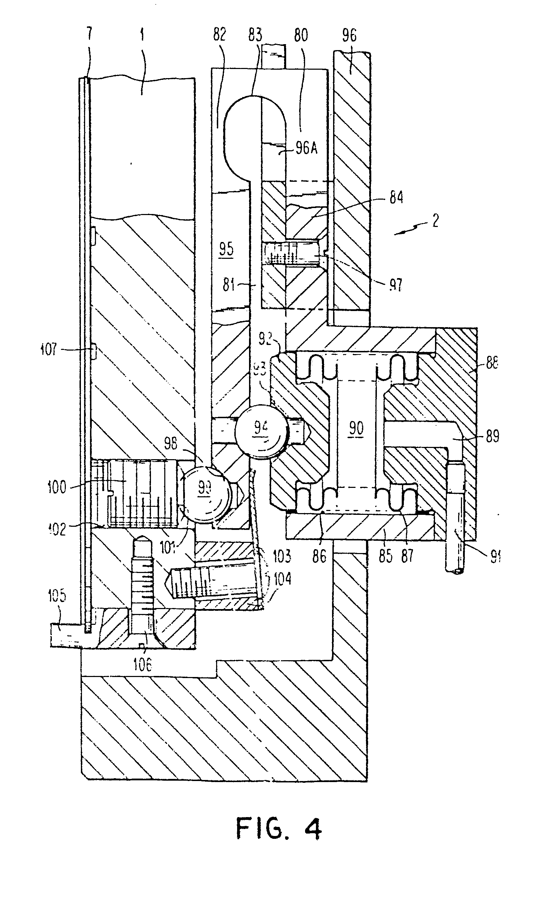

Es sind, wie bereits erwähnt, insgesamt drei Biegeeinheiten 2 vorgesehen, die jeweils um 120° versetzt und in Ausrichtung zu den Abtastköpfen 5 angeordnet sind. Die Biegeeinheiten 2 bestehen, wie aus Fig. 4 ersichtlich, aus einem Metallblock 80, welcher durch einen Einschnitt 81 gabelförmig gestaltet ist. Mittels einer Einbuchtung 83 ist eine dünne Biegeverbindung 82 gebildet, wodurch Auslenkbewegungen mit verhältnismäßig geringen Kräften durchgeführt werden können. Der Schenkel 84 trägt einen Ansatz 85 mit einer Bohrung 86 zur Aufnahme eines Faltenbalges 87. Dieser ist in der Bohrung 86 mittels einer Kappe 88 abgedichtet und an einem Kanal 89 angeschlossen, welcher die Balgkammer 90 mit einer Mündung 91 verbindet. Das entgegengesetzte Ende des Faltebalgs ist mit einer weiteren Kappe 92 abgedichtet, in welcher sich ein Konkavsitz 93 zur Aufnahme einer Kugel 94 befindet, die normalerweise im wesentlichen druckfrei an dem Biegearm 95 des Metallblocks 80 anliegt. Der Schenkel 84 des dargestellten Biegelements ist mittels Schrauben 97 an einem Rahmenjoch 96A der Wand 96 des Saugkopfes 14 befestigt.

Am Ende des Biegearmes 95 befindet sich ein Konkavsitz 98 für eine Kugel 99, welche andererseits gegen einen Konkavsitz 101 einer Lagerschraube 100 anliegt, die ihrerseits in eine Gewindebohrung 102 des Trägersockels 1 eingeschraubt ist. Der Metallblock 80 liegt mit dem Biegearm 95 an der Kugel 99 an und ist in dieser Lage mittels einer Blattfeder 103 gesichert, die an einem Auge 104 an der Unterseite des Trägersockels 1 befestigt ist. An der Umfangsfläche des Trägersockels 1 ist weiterhin ein mittels einer Schraube 106 befestigter Richtstift 105 angeordnet, der mit entsprechenden Richtnuten oder -kerben des Werkstücks zusammenwirkt, um dieses in bezug auf den Trägersockel 1 auszurichten. Vakuumnuten 107 in der Oberfläche des Trägersockels 1 dienen zum Festhalten des Werkstücks 7, und zur Zufuhr des Vakuums sind diese über eine Leitung 108 an eine entsprechende Vakuumquelle angeschlossen. Wie Fig. 2 weiterhin zeigt, ist der Faltenbalg 87 über eine an die Mündung 91 (Fig. 4) angeschlossene Leitung 109 mit der Antriebseinheit 9 verbunden.

Lagestifte 110, unter gleichem Winkelabstand am Saugkopfsockel 3 angebracht, dienen im Zusammenwirken mit den Registrierstiften 20 zur Ausrichtung bei der Montage der Grundplatte 4 (Fig. 3). Der Saugkopfsockel 3 wird sodann über die Wirkung der Vakuumnuten 13 an der Grundplatte 4 befestigt. Die Grundplatte 4 ist ihrerseits über einen Fokussierring 113 mit einer Schlittenplatte 112 verbunden, wobei als Verbindungsmittel eine zwischen Federstiften 115 und 116 gespannte Zugfeder 114 in Bohrungen 117 und 118 in der Grundplatte 4 und dem Fokussierring 113 dient, von denen drei, gleichmäßig am Umfang verteilt, vorgesehen sind sowie Blattfedern 114A, welche ebenfalls über den Umfang gleichmäßig verteilt sind. Die Blattfedern 114A sind in einem Hebelarm 116A eingespannt, welcher über eine Kugel 117A an der Schlittenplatte 112 anliegt. Eine Schraube 118A am einen Ende des Hebelarms 116A liegt auf der Schlittenplatte 112 an, wodurch die Lage des Hebelarms 116A zur Ausrichtung mit der Fläche 19 der Grundplatte 4 in bezug auf die Abbildungsebene verändert werden kann. Nach der Einstellung des Hebelarms 116A wird dieser mittels einer Feststellschraube 120 in der Bohrung 121 des Hebelarms 116A in bezug auf die Schlittenplatte 112 fixiert. Im Fokussierring 113 befindet sich ein Kanal 130 zur Zufuhr von Druckluft oder Vakuum, dessen entgegengesetztes Ende in die der Grundplatte 4 zugewandten Fläche des Fokussierringes 113 mündet. Der Kanal 130 hat den Zweck, die Lage des Fokussierringes 113 und der Grundplatte 4 zueinander durch Vakuum zu fixieren, wenn erforderlich, nämlich während der Feinausrichtung des Werkstücks und während der darauffolgenden Belichtungsvorgänge desselben. Wenn hingegen eine Beweglichkeit des Fokussierringes 113 in bezug auf die Grundplatte 4 erforderlich ist, wird durch den Kanal 130 anstelle von Vakuum nunmehr Druckluft zugeführt, so daß zwischen den beiden Teilen ein Luftpolster erzeugt wird.

Gemäß Fig. 6 können zwei Saugkopfsockel verwendet werden, nämlich ein erster Saugkopfsockel 3', auf welchen das Werkstück geladen wird, während der zweite Saugkopfsockel 3 mit dem optischen System ausgerichtet ist. Zweckmäßigerweise ist jedem Paar von Biegeeinheiten 2 in den beiden Saugkopfsockeln 3 und 3' eine Antriebsanordnung 67 bis 70 zugeordnet.

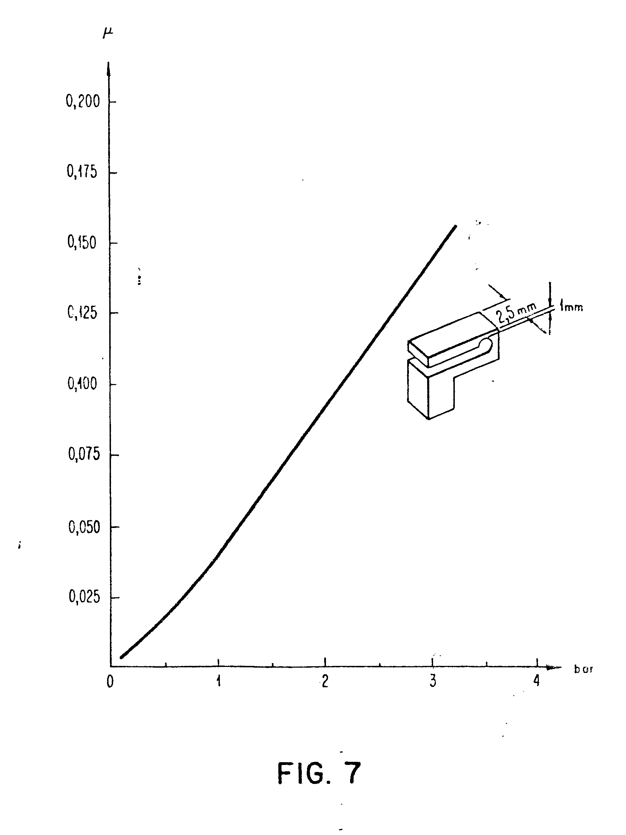

Zum Betreiben des beschriebenen Systems wird zunächst die Grundplatte 4 in bezug auf die vorgegebene Abbildungsebene 12 ausgerichtet, nämlich durch Justage des Fokussierringes 113 mittels des Hebelarms 116A, während die Abtastköpfe 5 in ihre Wirkstellung eingeschwenkt sind. Dann wird die hierbei verwendete optische Fläche zurückgezogen und ein Werkstück 7 auf den Trägersockel 1 aufgesetzt. Während der Saugkopfsockel 3 in der zuvor ausgerichteten Lage zur Grundplatte 4 mittels Vakuum in den Vakuumnuten 13 fixiert ist, kann das Ausrichtsystem für das Werkstück eingeschaltet werden. Hierzu werden die Abtastköpfe 5 über das Werkstück 7 eingeschwenkt und übermitteln in der beschriebenen Weise die Abtastsignale zum Differentialdruckschalter 8, welcher seinerseits Steuersignale über die Steuereinheit 66 zur Antriebseinheit 9 überträgt. Die Beziehung zwischen dem Steuerdruck und dem Verstellweg ist in Fig. 7 dargestellt. Danach kann der Biegearm 95 beispielsweise durch entsprechende Bemessung, wie in Fig. 7 gezeigt, so gestaltet werden, daß er einen nahezu linear ansteigenden Verstellweg bis zu 0,150 mm ausführt, während das Werkstück um einen Betrag von bis zu 0,075 mm aus der Parallelität zur Abbildungsfläche abweicht, bei einer Dikkentoleranz von maximal ±0,037 mm.

## Patentansprüche

1. Einrichtung zum planparallelen Feinausrichten plattenförmiger Werkstücke, z. B. Halbleiterwafer, zu einer Referenzebene, z. B. in die Abbildungsebene eines optischen Systems, bei der über einem im wesentlichen parallel zur Abbildungsebene (12) angeordneten höhenverstellbaren Trägersockel (1) für das Werkstück (7) eine Anzahl in gleichmäßigem Winkelabstand über der Werkstückoberfläche verteilte berührungsfreie Abtastelemente (5, 6) angeordnet sind, denen eine entsprechende Anzahl dazu fluchtender, rechtwinklig zur Werkstückoberfläche wirksamer Stelltriebe (9, 80 bis 104, 109) zugeordnet sind, denen über Wandler (8, 66) die Signale der Abtastelemente (5, 6) als Steuersignale zugeführt werden, dadurch gekennzeichnet, daß jeder der Stelltriebe als Biegeeinheit (2) gestaltet ist, bestehend aus einem gabelförmig eingeschnittenen Metallblock (80) mit einem an einer Grundplatte (4) befestigten Schenkel (84), einem mit dem Trägersockel (1) wirkungsverbundenen Biegearm (95) und einem den Schenkel (84) und den Biegearm (95) verbindenden Biegesteg (82), sowie aus einem zwischen Schenkel (84) und Biegearm (95) angeordneten, über eine Kugel (94) auf den Biegearm (95) wirksamen Feinhubtrieb (9, 87 bis 93).

2. Einrichtung nach Anspruch 1, dadurch gekennzeichnet, daß der Feinhubtrieb einen durch pneumatische Stellsignale verstellbaren Faltenbalg (87) aufweist, der in einer im Schenkel (84) angeordneten Balgkammer (90) geführt ist.

## Claims

1. Device for the plane-parallel precision alignment of plate-shaped workpieces, e. g. semiconductor wafers, to a reference plane, e. g. in the imaging plane of an optical system, where over a height-adjustable pedestal (1) for the workpiece (7) arranged substantially in parallel to the imaging plane (12) a number of non-contact sensing elements (5, 6) are equiangularly disposed over the workpiece surface which have a corresponding number of associated drivers (9, 80 to 104, 109) in alignment therewith and operative rectangularly to the workpiece surface, to which the signals of the sensing elements (5, 6) are applied via transducers (8, 66), characterized in that each of the drivers is designed as a flexure unit consisting of a kerfed metal block (80) with a leg (84) affixed to a base plate (4), a flexure arm (95) operatively connected to the carrier base (1), and a flexure path (82) connecting the leg (84) and the flexure arm (95), and of a precision drive (9, 87 to 93) arranged between leg (84) and flexure arm (95), and acting on the flexure arm (95) via a ball (94).

2. Device as claimed in claim 1, characterized in that the precision drive comprises a bellow (87) adjustable by pneumatic adjusting signals which are guided in a bellows chamber (90) arranged in the leg (84).

**Revendications**

1. Dispositif pour l'alignement précis de pièces planes, par exemple de pastilles semi-conductrices, avec un plan de référence tel le plan-image d'un système optique, où un grand nombre de capteurs sans contact (5, 6) sont disposés selon une même distance angulaire sur la surface de la pièce à travailler (7) elle-même supportée par un socle (1) de hauteur réglable et parallèle au plan-image (12), cesdits capteurs sans contact (5, 6) ayant un nombre correspondant d'éléments de commande (9, 80 à 104, 109) avec lesquels ils sont alignés, qui travaillent perpendiculairement par rapport à la surface de la pièce à travailler, et qui reçoivent des signaux de commande délivrés par lesdits capteurs (5, 6), à travers des transducteurs (8, 66), caractérisé en ce que chaque élément de commande est conçu comme une unité de flexion (2) constituée d'une pièce métallique en forme de fourche (80) avec un bras (84) fixé à l'embase (4), un bras de flexion (95) raccordé au socle-support (1) et une partie flexible (82) raccordée au bras de flexion (95), ainsi que d'un élément de précision de levage (9, 87 à 93), disposé entre ledit bras de fixation (84) et ledit bras de flexion (95), et qui sollicite ledit bras de fixation par l'intermédiaire d'une bille (94).

2. Dispositif selon la revendication 1, caractérisé en ce que ledit élément de précision de levage comporte un soufflet (87) réglable par des signaux de commande pneumatiques appliqués dans une chambre du soufflet (90) disposé dans le bras de fixation (84).

FIG. 1

FIG. 2

# 0 012 911

FIG. 2A

FIG. 3

11

FIG. 3A

FIG. 4

FIG. 5

FIG. 6

FIG. 7